# FASCICULE DE BREVET EUROPEEN

(11) **EP 0 778 666 B1**
(45) Date de publication et mention de la délivrance du brevet: **05.09.2001**
(21) Numéro de dépôt: 96120299.1
(22) Date de dépôt: 18.12.1996
(51) Int. Cl.: H03H 9/10

(54) **Résonateur piézoélectrique**
Piezoelektrischer Resonator
Piezoelectric resonator

(30) Priorité: 28.12.1995 FR 9515636
(43) Date de publication de la demande: 11.06.1997
(73) Titulaire: Eta SA Fabriques d'Ebauches, 2540 Grenchen (CH)
(72) Inventeur: Gottier, Hans-Rudolf, 2553 Safnern (CH)
(74) Mandataire: Barbeaux, Bernard

(56) Documents cités:
- CH-A- 678 471
- PATENT ABSTRACTS OF JAPAN vol. 014, no. 429 (E-0978), 14 Septembre 1990 & JP 02 166910 A (MATSUSHIMA KOGYO CO LTD), 27 Juin 1990,

## Description

La présente invention concerne les résonateurs piézoélectriques qui comprennent un élément vibrant monté dans un boîtier étanche et plus particulièrement les résonateurs à quartz de petites dimensions qui sont utilisés le plus souvent pour la réalisation de générateurs de fréquences notamment pour des équipements électroniques portables, dans de nombreux domaines comme l'horlogerie, l'informatique, les télécommunications et la médecine.

La plupart des résonateurs à quartz de petites dimensions que l'on trouve actuellement sur le marché peuvent être classés en deux catégories : les résonateurs dits "à boîtier céramique" et les résonateurs dits "à boîtier métallique".

Les boîtiers des résonateurs qui appartiennent à la première catégorie sont des boîtiers relativement plats qui comprennent généralement une partie principale de forme parallélépipédique en matériau céramique, à l'intérieur de laquelle est monté l'élément vibrant en quartz, un couvercle rectangulaire en verre, en céramique ou en métal, qui est soudé par l'intermédiaire d'un joint étanche sur la partie principale et un système de connexion qui peut se présenter sous différentes formes pour relier électriquement les électrodes d'excitation de l'élément vibrant à l'extérieur du boîtier.

Quelle que soit la façon dont ils sont conçus et réalisés dans le détail, ces résonateurs reviennent cher.

Les boîtiers des résonateurs qui font partie de la seconde catégorie sont des boîtiers de forme allongée qui comprennent une embase de contour essentiellement cylindrique sur laquelle est chassé un capot métallique également cylindrique, qui peut être fabriqué avantageusement par emboutissage. Dans ce cas, la liaison électrique entre les électrodes de l'élément vibrant et l'extérieur du boîtier est assurée par deux fils ou deux bandes métalliques qui traversent une partie isolante de l'embase et dont les extrémités internes sont soudées ou collées à l'aide d'une colle conductrice sur des plages de contact de l'élément vibrant, de façon que ces fils ou ces bandes servent en même temps de support pour cet élément.

Les résonateurs à boîtier métallique qui peuvent être fabriqués de façon totalement automatisée reviennent beaucoup moins cher que les résonateurs à boîtier céramique. Leur coût peut être deux à trois fois moins élevé. Mais ils présentent aussi un certain nombre d'inconvénients.

Tout d'abord, du fait de la minceur de leurs capots, leurs boîtiers peuvent être assez facilement endommagés, par exemple lorsqu'ils sont transportés en vrac ou manipulés de façon automatique sur des machines.

D'autre part, il arrive fréquemment que la fixation d'un résonateur à boîtier métallique sur un support tel qu'un circuit imprimé se limite au soudage nécessaire des extrémités de ses pattes de connexion, c'est-à-dire des parties externes de ses fils ou de ses bandes métalliques, sur des parties conductrices de ce support et à un collage de son boîtier sur ce même support, notamment pour protéger le résonateur contre des vibrations ou des chocs. Or, comme le boîtier est cylindrique sa surface de contact ou d'appui sur le support est très petite ce qui fait que, même en étant collé dessus, il peut difficilement rigidifier la zone de ce support dans laquelle il se trouve. Donc, si le support n'est pas lui-même rigide et s'il peut être soumis à des déformations, ces dernières peuvent provoquer le décollage du boîtier et/ou la rupture des pattes de connexion du résonateur ou de leurs liaisons avec les parties conductrices du support.

Enfin, les résonateurs à boîtier métallique peuvent également poser des problèmes lorsqu'il s'agit de les monter automatiquement en surface, c'est-à-dire sur des circuits imprimés sans trous.

En effet, pour permettre ce genre de montage les résonateurs dont les pattes de connexion sont déjà coudées et prêtes à être soudées sur les circuits imprimés sont livrés dans des emballages en plastique en forme de bandes, enroulés ou non, qui présentent des logements séparés pour les recevoir et qui permettent non seulement de les transporter mais également de les extraire automatiquement de leurs logements pour les amener chacun sur un circuit imprimé, dans la position exacte où ils doivent être montés. Or, entre le moment où ils sont placés dans une bande et celui où ils en sont retirés les résonateurs peuvent tourner dans leurs logements et leurs pattes de connexion peuvent être déformées, ce qui rend le montage automatique de ces résonateurs plus compliqué qu'il ne devrait l'être.

Il existe actuellement une solution qui permet d'éliminer les inconvénients des résonateurs à boîtier métallique dont on vient de parler.

Cette solution connue et utilisée déjà depuis plusieurs années consiste à mouler par injection autour du boîtier un bloc de matière plastique qui l'enveloppe complètement, sauf du côté de l'embase, et qui donne à l'ensemble la forme générale d'un parallélépipède rectangle. Du côté de l'embase, le bloc de matière plastique ne recouvre qu'à peu près la moitié de la surface de celle-ci, cette moitié étant celle qui se trouve sous les pattes de connexion. D'autre part, cette partie du bloc sert de forme pour le coudage des pattes de connexion dont les extrémités sont rabattues sous ce bloc.

Les résonateurs de ce genre qui sont plus spécialement conçus pour le montage en surface présentent eux aussi des inconvénients.

Premièrement, leur fabrication nécessite des opérations et des matériaux supplémentaires et une installation de moulage par injection qui augmentent leur prix de revient et, deuxièmement, leur volume est nettement plus important que celui d'un résonateur à boîtier métallique classique, ce qui est gênant lorsqu'il s'agit de les utiliser dans des instruments ou des appareils de petites dimensions.

Le document CH 678 471 A5 représente l'état de la technique le plus proche.

La présente invention vise à fournir un résonateur piézoélectrique à boîtier métallique qui présente tous les avantages des résonateurs connus de ce type mais pas leurs inconvénients.

Autrement dit, l'invention a pour but de fournir un résonateur piézoélectrique à boîtier métallique étanche, de faible volume et de faible coût, qui peut être fabriqué de façon entièrement automatique et dont le boîtier présente une bonne résistance mécanique.

De plus, ce résonateur doit être capable de consolider localement le support sur lequel il est monté lorsque ce support n'est pas lui-même rigide et qu'il peut subir des déformations.

Enfin, un autre but de l'invention est que ce résonateur se prête bien à un montage automatique en surface mais sans que cela empêche ou complique son montage d'une autre manière sur un support.

Ces buts sont atteints grâce au fait que dans le résonateur piézoélectrique selon l'invention qui comprend un élément vibrant muni d'électrodes et un boîtier étanche, de forme allongée qui contient l'élément vibrant et qui comporte un capot métallique, une embase sur laquelle est fixé ce capot et des conducteurs de liaison qui traversent ladite embase et qui ont des extrémités internes reliées électriquement aux électrodes de l'élément vibrant, le capot métallique du boîtier est constitué par une pièce en forme de parallélépipède rectangle qui présente dans le sens de sa longueur un trou axial borgne cylindrique.

D'autres caractéristiques et avantages de l'invention apparaîtront à la lecture de la description qui suit et qui se réfère au dessin annexé sur lequel :
- la figure 1 est une vue en perspective d'une forme préférée de réalisation du résonateur selon l'invention;
- la figure 2 est une vue en coupe longitudinale de ce même résonateur, selon le plan II-II de la figure 1; et
- la figure 3 est une vue agrandie de la zone A de la figure 2.

Tel qu'il est représenté sur le dessin, le résonateur selon l'invention comprend un boîtier étanche 1 dans lequel est enfermé sous vide ou sous atmosphère de gaz inerte un élément vibrant 2 comprenant un diapason en quartz 3 dont la base 4 et les branches 5 portent des métallisations 6. Les métallisations 6 forment sur les branches 5 des électrodes 7 qui permettent de les soumettre à des champs électriques et de les faire vibrer selon un mode déterminé et sur la base 4 des plages de connexion 8 pour l'élément vibrant.

La forme et la disposition des métallisations 6 sur le diapason 3 ne seront pas décrites ici car elles dépendent des caractéristiques de ce dernier et de la façon dont les branches 5 doivent vibrer (flexion, torsion ou autre).

Le boîtier 1 comprend les mêmes parties que celui des résonateurs à boîtier métallique dont on a parlé précédemment, c'est-à-dire un capot métallique allongé 9, une embase 10 de forme essentiellement cylindrique, sur laquelle est chassé le capot 9 et deux conducteurs 11 isolés électriquement l'un de l'autre, qui traversent l'embase 10 et qui servent à la fois à relier électriquement l'élément vibrant 2 avec l'extérieur du boîtier et à supporter cet élément à l'intérieur dudit boîtier. Pour cela, les conducteurs 11 ont leurs extrémités internes 11a fixées par de petits amas de colle conductrice 12 sur les plages de connexion 8 de l'élément vibrant.

Conformément à l'invention, le capot métallique 9 est constitué par une pièce en forme de parallélépipède rectangle, qui présente dans le sens de sa longueur un trou axial borgne cylindrique 14.

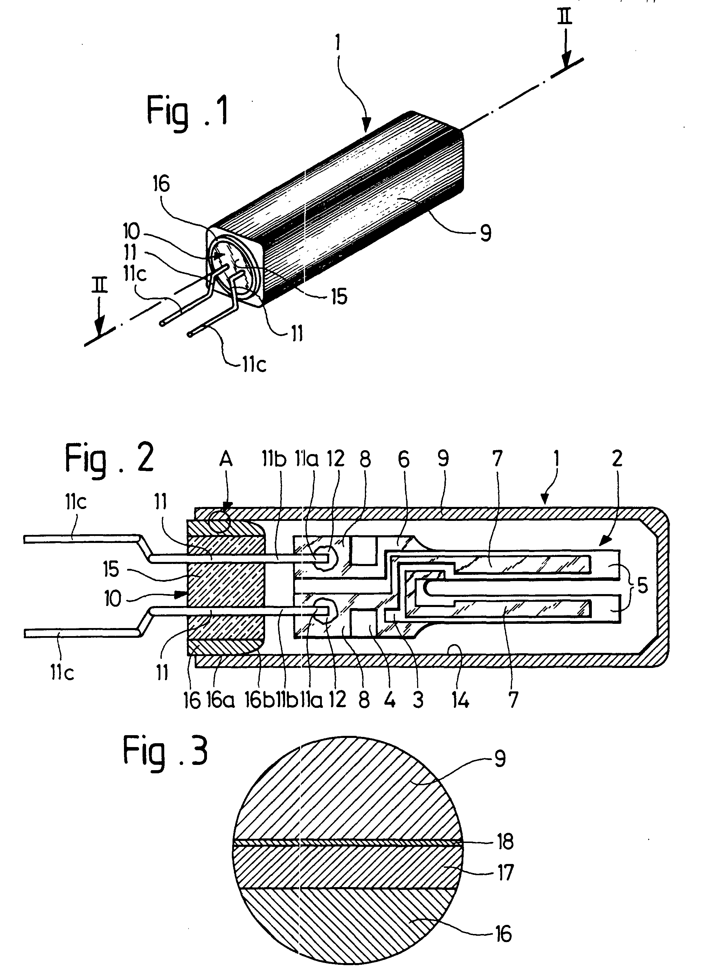

Comme le montre la figure 1, cette pièce est de section carrée, ce qui fait que le résonateur 1 n'est pratiquement pas plus encombrant qu'un résonateur ayant un capot cylindrique de même longueur que celle du capot 9 et un diamètre extérieur égal à la longueur des côtés de la section droite de ce dernier.

Par contre, grâce à sa forme parallélépipédique, le capot 9 du résonateur selon l'invention est beaucoup plus massif et par conséquent beaucoup plus rigide et beaucoup plus résistant mécaniquement qu'un capot cylindrique.

De plus, le capot 9 peut être fabriqué facilement et à faible coût en partant d'une barre de section carrée en un matériau métallique comme le maillechort ou le laiton, qui est à la fois facile à usiner et capable de se déformer élastiquement au moment du chassage du capot sur l'embase 10, en perçant dans cette barre, à l'une de ses extrémités et par décolletage, un trou longitudinal cylindrique, de profondeur et diamètre déterminés et en séparant ensuite la pièce qui constitue le capot du reste de la barre par découpage. Naturellement, il serait également possible de faire l'inverse, c'est-à-dire de commencer par découper la barre pour obtenir une pièce parallélépipédique pleine, de longueur voulue et de percer ensuite dans celle-ci un trou longitudinal cylindrique borgne, également par décolletage.

D'autre part, il apparaît déjà clairement que grâce à la forme parallélépipédique de leur capot, les résonateurs comme le résonateur 1 ne présentent pas les inconvénients des résonateurs à boîtier cylindrique classiques, en ce qui concerne leur transport dans des bandes et leur montage automatique sur des supports, notamment des circuits imprimés, et s'il s'avère que leur surface d'appui est encore insuffisante, il est facile de résoudre ce problème en munissant ces résonateurs de boîtiers à section non pas carrée mais rectangulaire, autrement dit de boîtiers plus larges que celui qui est représenté à la figure 1 mais ni plus hauts ni plus longs que celui-ci si l'on souhaite augmenter le moins possible le volume de ces boîtiers.

Enfin, il y a encore une autre raison pour laquelle il est intéressant d'avoir un boîtier parallélépipédique plutôt que cylindrique. Cette raison est la suivante :

Lorsque l'on réalise un boîtier de résonateur, on s'arrange toujours pour que la masse et la rigidité de ce boîtier soient adaptées aux caractéristiques de l'élément vibrant afin que le résonateur complet présente, entre autres, de très bonnes performances électriques et pour qu'il les conserve le plus longtemps possible.

Pour un boîtier cylindrique de longueur donnée et dont l'embase reste la même, cette adaptation ne peut se faire qu'en modifiant l'épaisseur du capot.

Pour un boîtier parallélipipédique, il est possible au contraire de changer la longueur de chaque côté de la section du capot si celle-ci est carrée ou la largeur et/ou l'épaisseur de ce capot si sa section est rectangulaire, ce qui permet une adaptation à la fois plus libre et plus précise que celle qui peut être effectuée pour un boîtier à capot cylindrique.

Cela dit, dans le cas d'un résonateur à boîtier métallique classique, les contraintes internes auxquelles le capot est soumis dans sa partie qui entoure l'embase sont réparties uniformément autour de celle-ci, vu que ce capot a partout la même épaisseur.

Par contre, dans le cas d'un capot parallélépipédique les contraintes ne sont plus les mêmes dans les coins que dans les parties les plus minces.

Pour cette raison, on pourrait penser que pour réaliser un boîtier parallélépipédique dont l'étanchéité est aussi bonne et aussi durable que celle d'un boîtier cylindrique il est nécessaire de concevoir une nouvelle embase ou tout au moins de prévoir pour les diamètres de cette embase et du trou du capot des tolérances encore plus sévères que celles qui doivent être respectées pour la fabrication d'un résonateur à boîtier cylindrique.

Or, l'expérience a montré qu'il n'en est rien et que l'on peut très bien utiliser la même embase et avoir les mêmes tolérances dans les deux cas, ce qui est un autre avantage du résonateur selon l'invention.

Telle qu'elle est représentée sur la figure 2, cette embase comprend une partie cylindrique centrale 15 en matériau isolant, plus précisément en verre, qui est traversée par les conducteurs 11 et qui est entourée par un anneau 16 constitué d'un matériau métallique capable de très bien adhérer au verre, ayant pratiquement le même coefficient de dilatation thermique que ce dernier et se prêtant bien à un traitement galvanique, ce qui est le cas par exemple pour l'alliage de nickel, de cobalt et de fer connu sous la marque "KOVAR" et l'alliage de fer et de nickel appelé "alloy 42".

Comme on peut le voir sur cette même figure, la surface extérieure de l'anneau 16 présente, du côté opposé à celui où se trouve l'élément vibrant 2, une partie principale cylindrique 16a qui représente à peu près les sept dixièmes de sa largeur et une partie approximativement en forme de zone sphérique 16b qui facilite l'introduction de l'embase 10 dans le capot 9 et le centrage de ce dernier au moment où il est chassé sur l'embase.

A noter que pour faciliter encore davantage l'introduction de l'embase 10 dans le capot 9 il est possible de chanfreiner le bord interne de ce capot.

D'autre part, comme le montre la figure 3, la surface extérieure de l'anneau 16 est recouverte de deux couches métalliques 17 et 18.

La première couche 17 qui est une couche galvanique relativement épaisse, par exemple d'environ 10 µm, est une couche élastiquement déformable qui est comprimée lors du chassage du capot sur l'embase et qui grâce à cette déformation permet d'assurer l'étanchéité du boîtier 1. De préférence, cette couche 17 est formée elle-même de plusieurs couches, par exemple d'une couche de cuivre, d'une couche d'alliage de plomb et d'étain et d'une couche d'argent.

La deuxième couche 18 qui est environ dix à cinquante fois plus mince que la couche 17 est une couche d'or également galvanique et déformable, qui a pour rôle de protéger la surface métallique de l'embase contre l'oxydation et d'autres phénomènes qui pourraient la détériorer et d'assurer que cette surface reste propre entre le moment de la fabrication de l'embase et celui de son assemblage avec le capot.

En ce qui concerne les conducteurs 11, ceux-ci sont constitués par des fils de petit diamètre, fabriqués au départ en un matériau ayant les mêmes propriétés que celles qui ont été indiquées précédemment à propos du matériau qui forme l'anneau 16 et qui peut donc être lui aussi du "KOVAR" ou de l'alloy 42.

Comme ces fils ont subi les mêmes traitements galvaniques que l'embase 16, leurs parties internes 11b qui supportent l'élément vibrant 2 et leurs parties externes 11c qui forment des pattes de connexion pour le résonateur sont recouvertes par les mêmes couches 17 et 18 que l'embase. Ces couches ne sont pas inutiles car on a constaté que pour certains adhésifs la couche d'or 18, en particulier, permettait d'augmenter la fiabilité des collages des extrémités des fils 11 sur les plages de connexion 8 de l'élément vibrant 2 et que cette même couche permettait aussi, dans certains cas, de rendre plus fiables les soudures des pattes de connexion du résonateur sur un support.

Telles qu'elles sont représentées sur le dessin, ces pattes de connexion sont plus spécialement prévues pour un montage en surface du résonateur. C'est la raison pour laquelle elles ont été pliées deux fois, à peu près à 90°, de façon que leurs extrémités soient sensiblement parallèles à l'axe longitudinal du résonateur et tangentes au plan dans lequel se trouve la face du capot 9 qui sera en contact avec le support sur lequel le résonateur sera monté.

Cela dit, il est bien clair que l'invention n'est pas limitée à la forme d'exécution qui vient d'être décrite.

En particulier, les pattes de connexion pourraient avoir une autre forme et être par exemple simplement droites.

Les extrémités internes des conducteurs pourraient être soudées et non pas collées sur les plages de connexion de l'élément vibrant et ces conducteurs pourraient ne pas être des fils mais des bandes métalliques minces et étroites.

Par ailleurs, l'embase pourrait être réalisée différemment par exemple sous la forme d'un bloc sensiblement cylindrique et essentiellement métallique, avec seulement deux petits manchons en matière isolante aux endroits ou passent les conducteurs de liaison.

De plus, le capot pourrait être nickelé ou chromé et ne pas être chassé mais soudé sur l'embase.

Enfin, il est bien évident que l'élément vibrant pourrait avoir une autre forme que celle d'un diapason, par exemple celle d'un barreau, et que quelle que soit sa forme cet élément pourrait être supporté dans le boîtier par des moyens autres que les conducteurs de liaison eux-mêmes, par exemple des barres de suspension solidaires de l'embase. Dans certains cas, l'élément vibrant pourrait même être collé directement, par l'une de ses extrémités, sur cette embase.

## Revendications

1. Résonateur piézoélectrique comprenant un élément vibrant (2) muni d'électrodes (7) et un boîtier étanche (1) de forme allongée, contenant ledit élément vibrant et comportant un capot métallique (9), une embase (10) sur laquelle est fixée ledit capot et des conducteurs de liaison (11) traversant ladite embase et ayant des extrémités internes (11a) reliées électriquement auxdites électrodes de l'élément vibrant, caractérisé par le fait que ledit capot métallique (9) est constitué par une pièce en forme de parallélépipède rectangle qui présente dans le sens de sa longueur un trou axial borgne cylindrique (14).

2. Résonateur selon la revendication 1, caractérisé par le fait que ladite pièce en forme de parallélépipède rectangle présente une section sensiblement carrée.

3. Résonateur selon la revendication 1 ou 2, caractérisé par le fait que ledit capot (9) est en maillechort.

4. Résonateur selon l'une quelconque des revendications précédentes, caractérisé par le fait que ledit capot (9) est chassé sur ladite embase (10).

5. Résonateur selon la revendication 4, caractérisé par le fait que ladite embase (10) comprend une partie centrale cylindrique (15) en matériau électriquement isolant, qui est traversé par lesdits conducteurs (11), un anneau métallique (16) entourant ladite partie centrale cylindrique et au moins une couche métallique (17) recouvrant la surface extérieure dudit anneau et capable de se déformer élastiquement, qui est comprimée lorsque ledit capot (9) est chassé sur ladite embase (10) pour assurer l'étanchéité dudit boîtier (1).

6. Résonateur selon la revendication 5, caractérisé par le fait que ladite couche métallique (17) est elle-même recouverte d'une mince couche d'or (18).

7. Résonateur selon la revendication 5 ou 6, caractérisé par le fait que ladite partie centrale cylindrique (15) est en verre.

8. Résonateur selon l'une quelconque des revendications précédentes, caractérisé par le fait que les extrémités internes (11a) des conducteurs de liaison (11) sont fixées sur l'élément vibrant (2) et supportent celui-ci à l'intérieur dudit boîtier (1).

9. Résonateur selon la revendication 8, caractérisé par le fait que les extrémités internes (11a) des conducteurs de liaison (11) sont fixées sur l'élément vibrant (2) au moyen d'une colle conductrice.

10. Résonateur selon l'une quelconque des revendications précédentes, caractérisé par le fait que ledit élément vibrant (2) comprend un diapason en quartz (3) dont les branches (5) portent lesdites électrodes (7).

## Claims

1. Piezoelectric resonator comprising a vibrating element (2) provided with electrodes (7) and a tight sealed housing (1) of elongated shape, containing said vibrating element and comprising a metal cap (9), a base (10) on which said cap is fixed and coupling conductors (11) passing through said base and having internal ends (11a) electrically connected to said electrodes of the vibrating element, **characterized in that** said metal cap (9) is formed by a part in the shape of a rectangular parallelepiped which has in its lengthways direction a cylindrical axial blind hole (14).

2. Resonator according to claim 1, **characterized in that** said part in the shape of a rectagular parallelepiped has a substantially square section.

3. Resonator according to claim 1 or 2, **characterized in that** said cap (9) is made of copper-nickel-zinc alloy.

4. Resonator according to any of the preceding claims, **characterized in that** said cap (9) is driven onto said base (10).

5. Resonator according to claim 4, **characterized in that** said base (10) comprises a central cylindrical part (15) of an electrically insulating material, through which said conductors (11) pass, a metal ring (16) surrounding said central cylindrical part and at least one metal layer (17) covering the external surface of said ring and capable of being elastically deformed, which is compressed when said cap (9) is driven onto said base (10) to assure the tight sealing of said housing (1).

6. Resonator according to claim 5, **characterized in that** said metal layer (17) is itself covered with a thin layer of gold (18).

7. Resonator according to claim 5 or 6, **characterized in that** said central cylindrical part (15) is made of glass.

8. Resonator according to any of the preceding claims, **characterized in that** the internal ends (11a) of the coupling conductors (11) are fixed onto the vibrating element (2) and support the latter within said housing (1) .

9. Resonator according to claim 8, **characterized in that** the internal ends (11a) of the connecting conductors (11) are fixed onto the vibrating element (2) by means of a conductive adhesive material.

10. Resonator according to any of the preceding claims, **characterized in that** said vibrating element (2) comprises a quartz tuning-fork (3) whose branches (5) bear said electrodes (7).

## Patentansprüche

1. Piezoelektrischer Resonator, der ein schwingendes Element (2), das mit Elektroden (7) versehen ist, sowie ein dichtes Gehäuse (1) mit langgestreckter Form, das das schwingende Element enthält und einen metallischen Deckel (9), eine Bodenplatte (10), auf der der Deckel befestigt ist, und Verbindungsleiter (11), die durch die Bodenplatte verlaufen und innere Enden (11a) besitzen, die mit den Elektroden des schwingenden Elements elektrisch verbunden sind, umfaßt, **dadurch gekennzeichnet**, daß der metallische Deckel (9) durch ein Teil in Form eines rechteckigen Parallelepipeds gebildet ist, das in Längsrichtung ein axiales zylindrisches Blindloch (14) aufweist.

2. Resonator nach Anspruch 1, **dadurch gekennzeichnet**, daß das Teil in Form eines rechteckigen Parallelepipeds einen im wesentlichen quadratischen Querschnitt aufweist.

3. Resonator nach Anspruch 1 oder 2, **dadurch gekennzeichnet**, daß der Deckel (9) aus einer Nickel-Kupfer-Zinklegierung hergestellt ist.

4. Resonator nach einem der vorhergehenden Ansprüche, **dadurch gekennzeichnet**, daß der Deckel (9) auf die Bodenplatte (10) gedrückt ist.

5. Resonator nach Anspruch 4, **dadurch gekennzeichnet**, daß die Bodenplatte (10) einen zylindrischen Mittelabschnitt (15) aus elektrisch isolierendem Material, durch den die Leiter (11) verlaufen, einen metallischen Ring (16), der den zylindrischen Mittelabschnitt umgibt, und wenigstens eine metallische Schicht (17) umfaßt, die die äußere Oberfläche des Rings abdeckt und sich elastisch verformen kann und komprimiert wird, wenn der Deckel (9) auf die Bodenplatte (10) gedrückt wird, um die Dichtheit des Gehäuses (1) zu gewährleisten.

6. Resonator nach Anspruch 5, **dadurch gekennzeichnet**, daß die metallische Schicht (17) ihrerseits durch eine dünne Goldschicht (18) bedeckt ist.

7. Resonator nach Anspruch 5 oder 6, **dadurch gekennzeichnet**, daß der zylindrische Mittelabschnitt (15) aus Glas besteht.

8. Resonator nach einem der vorhergehenden Ansprüche, **dadurch gekennzeichnet**, daß die inneren Enden (11a) der Verbindungsleiter (11) an dem schwingenden Element (2) befestigt sind und dieses im Inneren des Gehäuses (1) halten.

9. Resonator nach Anspruch 8, **dadurch gekennzeichnet**, daß die inneren Enden (11a) der Verbindungsleiter (11) am schwingenden Element (2) mittels eines leitenden Klebstoffs befestigt sind.

10. Resonator nach einem der vorhergehenden Ansprüche, **dadurch gekennzeichnet**, daß das schwingende Element (2) eine Quarz-Stimmgabel (3), deren Schenkel (5) die Elektroden (7) tragen, umfaßt.
